# EUROPEAN PATENT APPLICATION

(11) **EP 1 217 740 A2**
(43) Date of publication of application: **26.06.2002**
(21) Application number: 01309082.4
(22) Date of filing: 25.10.2001
(51) Int. Cl.: H03K 5/13

(54) **Adjustable phase shifter**

(30) Priority: 01.12.2000 US 726622
(71) Applicant: Hewlett-Packard Company, Palo Alto, CA 94304 (US)
(72) Inventor: Fischer, Michael C., Paolo Alto, CA 94303 (US)
(74) Representative: Jehan, Robert

(57) **Abstract**

Apparatus (100) and method (300) for adjusting the phase of an output digital signal while maintaining the symmetry of the input signal provide an input waveform signal (10) and a comparator (20) having a positive feedback path to an input and an output. An adjustable resistor (30) is connected along the positive feedback path to the output of the comparator (20) and to the positive input of the comparator (20). The apparatus (100) produces an output waveform signal (40) shifted in phase from the input waveform signal (10) with the same duty cycle as the input waveform signal (10).

## Description

This invention relates to electronic circuits and more particularly to a circuit or device for adjusting the phase of a digital signal while maintaining the symmetry of the input signal.

In communications and other signal processing applications, it is often necessary to adjust the phase of a signal so that it matches up with the phase of another signal, or to compensate for a time delay in the signal. This function has generally been performed by a monostable multi-vibrator, sometimes referred to as a "one-shot", with an adjustable pulse-width. This approach to adjusting the phase of a signal yields an output pulse-width that varies as the delay is changed. In many cases this is an undesirable effect.

The present invention seeks to provide improved adjustment of phase shifts.

According to an aspect of the present invention, there is provided apparatus for adjusting the phase of an input digital signal while maintaining the symmetry of the input signal as specified in claim 1.

According to another aspect of the present invention, there is provided a method of adjusting the phase of a digital signal as specified in claim 5.

According to another aspect of the present invention, there is provided a system for adjusting the phase of a digital signal as specified in claim 8.

The preferred embodiment can offer a simple, easy, and inexpensive means for changing the phase of a digital signal. It maintains the symmetry of the input signal, unlike the existing monostable vibrator. It thus allows the time-of-occurrence of a signal transition to be delayed by an adjustable amount. Examples for implementation of this include aligning a clock signal to a data stream, or use as a phase modulator to vary the phase of a carrier signal in response to a modulating signal in a predictable, linear manner.

What is described is an apparatus and a method for adjusting the phase of an output digital signal while maintaining the symmetry of the input signal. The apparatus includes an input waveform signal and a comparator having a positive feedback path to an input and an output. An adjustable resistor is connected along the positive feedback path to the output of the comparator and to the positive input of the comparator. The apparatus produces an output waveform signal shifted in phase from the input waveform signal with the same duty cycle as the input waveform signal.

Embodiments of the present invention are described below, by way of example only, with reference to the accompanying drawings, in which:
Figure 1 is a block diagram of one embodiment of an apparatus for adjusting the phase of an output digital signal while maintaining the symmetry of the input signal;
Figure 2a is a diagram illustrating a small hysteresis for the input and output waveforms;
Figure 2b is a diagram illustrating a large hysteresis for the input and output waveforms; and
Figure 3 is a flowchart of a method for adjusting the phase of an output digital signal while maintaining the symmetry of the input signal.

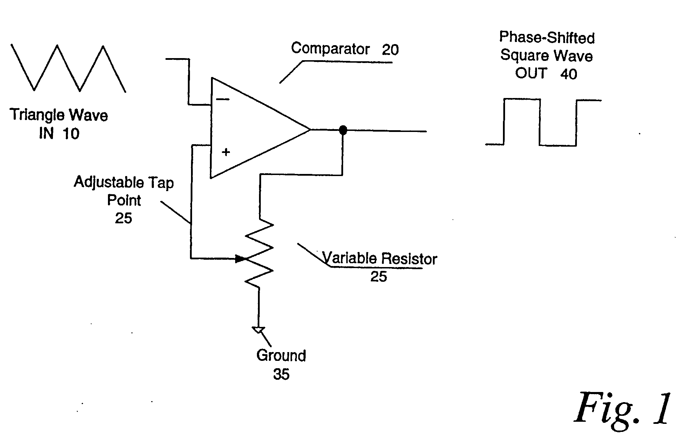

Figure 1 is a circuit diagram of a circuit 100 for adjusting the phase of an output digital signal while maintaining the symmetry of the input signal in the output signal according to one embodiment of the present invention. The circuit 100 includes a comparator 20, having a positive and a negative input and an output; a variable resistor 30, connected to the output of the comparator 20 at one end and to ground 35 at the other; and an adjustable tap point 25 connected to the positive input of the comparator at one end and to the variable resistor 30 at the other end.

The circuit 100 also includes a waveform signal input 10 connected to the negative input of a comparator 20. Although the preferred input is a symmetric triangle waveform, any waveform, either symmetric or non-symmetric, including sine waves, may be processed by the circuit.

The output of the circuit 100 is a phase-shifted square waveform signal output 40. As with the waveform signal input 10, the waveform signal output 40 may be other types of waveforms. The variable resistor 30 may be, for example, a rheostat, a potentiometer, or a field effect transistor, among others.

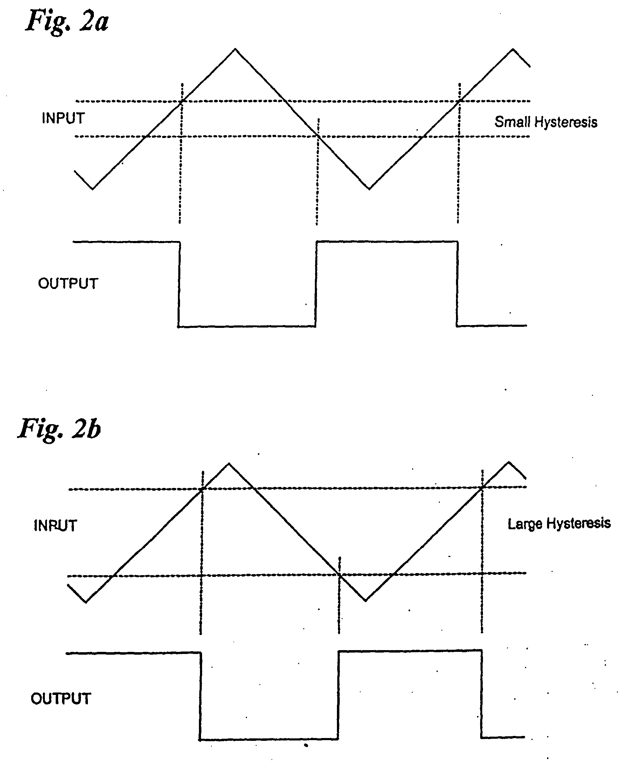

The adjustable tap point 25 is connected from the positive input of the comparator to the variable resistor 30. The adjustable tap point 25 may be manually manipulated to adjust the hysteresis of the triangle waveform signal input 10 and square waveform signal output 40. The hysteresis is determined by the intersection of the trailing and leading edges of the square waveform signal output 40 on the triangle waveform signal input 10, and is the difference between these two points, as seen in Figures 2a and 2b.

The shift in phase between the triangle waveform signal input 10 and the square waveform signal output 40 corresponds to the hysteresis caused by the adjustment of the variable resistor 30; as the hysteresis is adjusted, the phase is shifted. If the variable resistor 30 comprises a field effect transistor or other electronically variable resistance element, then the adjustable tap point 25, and thus also the hysteresis of the square waveform signal output 40, may be adjusted electronically.

The circuit 100 operates to adjust the phase of a signal by first accepting an waveform signal input 10 at the negative input of the comparator 20. This waveform signal input 10 is compared against a derived input signal (not shown) passed through the adjustable tap point 25 to the positive input of the comparator 20. The derived input signal passed through the adjustable tap point 25 is obtained from the effect of the variable resistor 30 that is connected to the output of the comparator 20 at one end and to ground 35 at the other. This establishes a positive feedback path between the output of the comparator 20 and the positive input of the comparator 20. The positive feedback path permits the introduction of the hysteresis resulting in a change in phase of the square waveform signal output 40. This feedback path, and therefore the phase difference between the waveform signal input 10 and the square waveform signal output 40, is adjustable by way of manipulation of the adjustable tap point 25 connected to the variable resistor 30.

With the tap point 25 set near the grounded end of its sliding range along the variable resistor 30, the hysteresis is brought to near zero and the square waveform signal output 40 is nearly in phase with respect to the waveform signal input 10. When the tap point 25 is adjusted to the upper limit of its sliding range, towards the output of the comparator 20, the resulting square waveform signal output 40 approaches 90 degrees out of phase from the waveform signal input 10.

It is noted that at a minimal hysteresis the square waveform signal output 40 is approximately in phase with the waveform signal input 10, and only a slight phase difference may be observed. Likewise, at the maximum amount of hysteresis the square waveform signal output 40 approaches being in quadrature with the waveform signal input 10.

Figure 2a and Figure 2b illustrate differing levels of hysteresis and the corresponding phase difference in the signals processed by the circuit 100. The input waveforms in both figures have the same phase, while the output waveform in Figure 2a lags the input waveform (it is out of phase). As seen in Figure 2b, however, the output waveform in Figure 2b is even more out of phase, illustrating a phase delay of approximately 30 degrees more than the output in Figure 2a. This is due to the change in hysteresis introduced by the circuit.

The amount of phase change corresponds to the hysteresis introduced. As the amount of the hysteresis is adjusted, as described above with reference to Figure 1, there is a corresponding change in the points on the waveform signal input 10 at which the comparator 20 changes state at its output. In other words, the points of intersection of the trailing edges and the leading edges of the square waveform signal output 40 move the same amount upward or downward as the variable resistor is adjusted, as seen in Figure 2a and Figure 2b. This causes the square waveform signal output 40 to maintain the same symmetry as the waveform signal input 10 when the phase of the square waveform signal output 40 is adjusted. For example, if the waveform signal input 10 is symmetrical (as shown in Figure 2a or Figure 2b), the square waveform signal output 40 will maintain this symmetry as the hysteresis is increased and the square waveform signal input's 10 trailing and leading edges are moved forward (i.e., delayed) by an equal amount.

As the hysteresis is increased, as in Figure 2b, the points on the waveform signal input 10 at which the comparator 20 changes state at its output occurs at a later time in the same amount for both the leading edge and the trailing edge. Thus, the symmetry of the waveform signal input 10 is preserved in the square waveform signal output 40 even as the phase shift is accomplished.

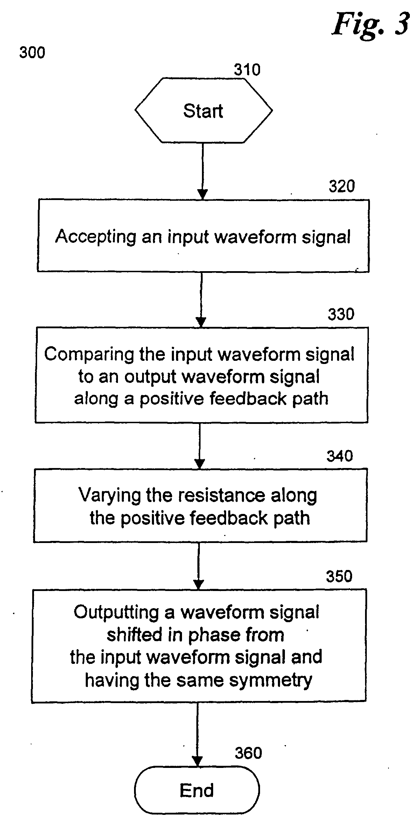

Figure 3 is a flowchart of a preferred method 300 of adjusting the phase of an output digital signal while maintaining the symmetry of the input signal. The method 300 comprises accepting or receiving 320 an input waveform signal. This input waveform signal is generally a symmetric triangle waveform signal, but may also be any other symmetric waveform signal, including a sine waveform signal.

The method 300 further comprises comparing 330 the input waveform signal to another waveform signal, or more particularly, an output waveform signal, received along a positive feedback path. The method 300 varies the resistance 340 along the positive feedback path in order to introduce hysteresis to the output waveform signal, and thereby to adjust the phase of the output waveform signal. Varying the resistance 340 may be accomplished either by manual adjustment or by automatic or electronic adjustment.

The method 300 produces an output waveform signal 350 shifted in phase from the input waveform signal. The output waveform signal produced maintains the symmetry of the input waveform signal.

The terms and descriptions used herein are set forth by way of illustration only and are not meant as limitations. Those skilled in the art will recognise that many variations are possible within the scope of the invention as defined in the following claims, and their equivalents, in which all terms are to be understood in their broadest possible sense unless otherwise indicated.

The disclosures in United States patent application no. 09/726,622, from which this application claims priority, and in the abstract accompanying this application are incorporated herein by reference.

## Claims

1. Apparatus (100) for adjusting the phase of an input digital signal while maintaining symmetry of the input signal, including :
means for inputting an input waveform signal (10) having a symmetry;
a comparator (20) including a positive feedback path to a positive input and an output;
an adjustable resistor (30) connected to the output of the comparator (20) and to the positive input of the comparator (20); and
an output waveform signal (40) shifted in phase from the input waveform signal (10), wherein the output waveform signal (40) has a symmetry that is substantially the same as the input waveform signal duty cycle.

2. Apparatus as in claim 1, wherein:
the input waveform signal (10) is a symmetric triangle wave; and
the output waveform signal (40) is a symmetric square wave.

3. Apparatus as in claim 1 or 2, wherein the variable resistor (30) includes:
a first terminal connected to the output of the comparator (20);
a second terminal that is grounded (35); and
an adjustable tap point (25) connected to the positive input of the comparator (20).

4. Apparatus as in claim 1, 2 or 3, wherein the variable resistor (30) is electronically adjustable.

5. A method (300) of adjusting the phase of an input digital signal while maintaining symmetry of the input signal, including the steps of:
accepting an input waveform signal (320);
comparing the input waveform signal to an output waveform signal along a positive feedback path (330);
varying the resistance along the positive feedback path between the output and a positive input (340); and
outputting a waveform signal shifted in phase from the input waveform signal (350).

6. A method as in claim 5, wherein the varying step (340) is performed manually.

7. A method as in claim 5, wherein the varying step (340) is performed electronically.

8. A system for adjusting the phase of an input digital signal while maintaining symmetry of the input signal, including:
a comparator (20) including a negative input, a positive input, an output and a positive feedback path to the positive input;
an adjustable resistor (30), including:
a first terminal connected to the output of the comparator (20);
a second terminal that is grounded (35); and
an adjustable tap point (25) connected to the positive input of the comparator (20);
means for receiving an input waveform signal (10) connected to the negative input of the comparator (20), wherein the input waveform signal has a symmetry; and
means for providing an output waveform signal (40), output from the comparator (20) output, wherein the output waveform signal (40) is shifted in phase from the input waveform signal (10) by adjusting the adjustable tap point (25) and wherein the output waveform signal (40) maintains a symmetry that is the same as the input waveform signal (10) symmetry.

9. A system as in claim 8, wherein:
the input waveform signal (10) is a symmetric triangle wave; and
the output waveform signal (40) is a symmetric square wave.

10. A system as in claim 8 or 9, wherein the variable resistor (30) is electronically adjustable.
